# EUROPEAN PATENT SPECIFICATION

(11) **EP 0 987 230 B1**
(45) Date of publication and mention of the grant of the patent: **30.06.2004**
(21) Application number: 99118329.4
(22) Date of filing: 15.09.1999
(51) Int. Cl.: C04B 35/46, H01P 1/205

(54) **Dielectric ceramic material**
Dielektrischer keramischer Werkstoff
Matériau céramique diélectrique

(30) Priority: 16.09.1998 JP 26165698
(43) Date of publication of application: 22.03.2000
(73) Proprietor: NGK SPARK PLUG CO., LTD, Mizuho-ku Nagoya-shi Aichi (JP)
(72) Inventor: Takase, Masanori, C/O NGK Spark plug Co., Ltd., Nagoya-shi, Aichi (JP); Yokoi, Hitoshi, C/O NGK Spark plug Co., Ltd., Nagoya-shi, Aichi (JP); Ohbayashi, Kazushige, C/O NGK Spark plug Co., Ltd., Nagoya-shi, Aichi (JP)
(74) Representative: Grünecker, Kinkeldey, Stockmair & Schwanhäusser Anwaltssozietät

(56) References cited:
- US-A- 5 320 991
- Specification sheet from Merck KGaA, Darmstadt, Product no. 100805, titanium dioxide extra pure (99%)

## Description

### Background of the Invention

### 1. Field of the invention

This invention relates to a dielectric ceramic material. More particularly, it relates to a dielectric ceramic material which exhibits excellent dielectric characteristics, i.e., a high relative dielectric constant (hereinafter represented by εᵣ) in a high frequency region, a high unloaded quality coefficient (hereinafter represented by Qᵤ), and a small absolute value of the temperature coefficient of resonance frequency (hereinafter resonance frequency is represented by f₀, and the temperature coefficient thereof is represented by τ_{f}). The dielectric ceramic material of the present invention is suited for use in multilayer circuit boards, resonators and filters particularly for use in a high frequency region, an impedance matching element for various microwave circuits, and the like.

### 2. Description of the Related Art

With the recent increase of communication information, rapid progress is being made in various communication systems utilizing the microwave region, such as mobile telecommunication systems, satellite communication systems, positioning systems using communication data, and satellite broadcasting. Use of the communication systems in a submillimeter wave region has been demanded. Many dielectric materials have been developed with the rapid progress. These dielectric materials are required to have (1) a high relative dielectric constant εᵣ, (2) a high unloaded quality coefficient Qᵤ (i.e., a small dielectric loss 1/Qᵤ), and (3) a small absolute value of τ_{f} (i.e., small temperature dependence of f₀).

In particular, a dielectric material used in a submillimeter wave region is required to have an especially high Qᵤ, and it is desirable that τ_{f} be controllable freely around 0 ppm/°C.

Microwave dielectric porcelain compositions based on Li₂O-CaO-Sm₂O₃-TiO₂ are disclosed in JP-A-5-211007 and JP-A-5-211009. These materials have a particularly excellent εᵣ value but a relatively small Qᵤ. While the τ_{f} is relatively controlled by the composition, the precise control has been difficult, and control to nearly 0 ppm/°C has not been realized as yet.

From US-A-5,320,991, a dielectric ceramic composition having a high dielectric constant and a large Q value and having a temperature coefficient which is close to 0 is known which is obtained by adding calcium oxide and sodium oxide which are mixed with each other in an adjusted ratio to lithium oxide, samarium oxide and titanium oxide, wherein an increase in the content of sodium oxide brings about an increase in the dielectric constant and an increase in the absolute value of the temperature coefficient while bringing about a decrease in the Q value.

It is an object of the present invention to provide a dielectric ceramic material which has a high Qᵤ value even in a submillimeter wave region, which can have its temperature coefficient τ_{f} controlled around 0 ppm/°C and which exhibits a high relative dielectric constant εᵣ.

The above object is achieved by the subject matter of claim 1. Preferred embodiments and further improvements are defined in the depending subclaims.

### Brief Description of the Drawings

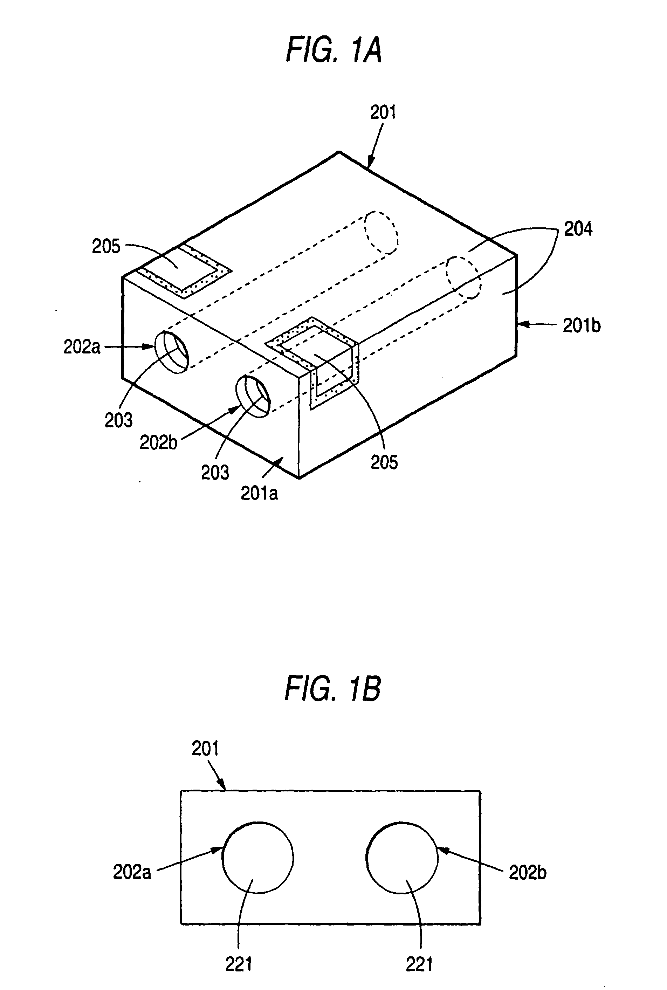

Fig. 1A is a perspective view of a dielectric filter utilizing the dielectric material of the present invention, and Fig. 1B is a front view taken from the open end surface of Fig. 1A.

### Detailed Description of the Invention

The present invention provides a dielectric ceramic material represented by composition formula:

(uLi₂O-vNa₂O)-wSm₂O₃-xCaO-(yTiO₂-zM₂O₃),

wherein M represents at least one of Ga and Al; u+v+w+x+y+z=100 mol%, 0≤u≤40, 0≤v≤40, 3≤u+v≤40, 8≤w≤30, 5<x≤40, 30≤y, 3≤z, and y+z≤80.

In the dielectric ceramic material of the invention, the molar ratio of Li oxide (u) and that of Na oxide (v) satisfy 0≤u≤40 and 0≤v≤40, respectively, and the total molar ratio of the Li oxide and the Na oxide (u+v) satisfies 3≤u+v≤40. That is, the dielectric ceramic material contains at least one of Li oxide and Na oxide. The total molar ratio u+v is equal to or greater than 3 and equal to or smaller than 15, still preferably equal to or greater than 5 and equal to or smaller than 8.

It is preferred that u and v satisfy 3≤u≤40 and 0≤v≤30. When u and v satisfy this ranges, it is preferred in the point that τ_{f} is not greatly shifted to the plus side.

According to the desired dielectric characteristics, Li oxide may be excluded from the composition in dielectric ceramic material of the invention.

If the dielectric ceramic material contains excessive Li oxide and Na oxide, Qᵤxf₀ tends to be small.

The molar ratio of Sm oxide (w) in the inventive dielectric ceramic material satisfies 8≤w≤30, preferably 8≤w≤20, still preferably 10<w≤16. Where Sm oxide is present in excess, εᵣ tends to be reduced.

The molar ratio of Ca oxide (x) in the inventive dielectric ceramic material satisfies 5<x≤40, preferably 5<x≤30, still preferably 9<x≤18. Where Ca oxide is present in excess, τ_{f} tends to be greatly shifted to the plus side.

The molar ratio of Ti oxide (y) in the inventive dielectric ceramic material satisfies 30≤y, preferably 30≤y≤77, still preferably 50≤y≤75.

The molar ratio of Ti oxide (y) and that of at least one of Ga and Al oxides (z) in dielectric ceramic material satisfy 30≤y and 3≤z. That is, dielectric ceramic material has part of Ti displaced with at least one of Ga and Al to contain at least one of Ga oxide and Al oxide. The total molar ratio of Ti oxide and at least one of Ga and Al oxides (i.e. y+z) satisfies y+z≤80, preferably y+z≤75, still preferably 60≤y+z≤70.

If the inventive dielectric ceramic material contains Ti oxide and Ga or Al oxide in excessive amounts, εᵣ tends to be low.

Qᵤxf₀ increases with the ratio of z to y in (yTiO₂-zM₂O₃), i.e., the degree of substitution of Ti with at least one of Ga and Al. However, if the degree of substitution exceeds 50 mol% based on the Ti oxide, εᵣ tends to decrease due to phase separation or change of the crystal structure. Accordingly, it is preferred that 40≤y<80 and 0≤z<40, particularly 30≤y≤60 and 3≤z≤35.

In the present invention, where 5≤u+v≤20, a εᵣ value of 75 or greater and Qᵤxf₀ of 6000 GHz or greater can be secured. In particular where u, v, w, x, and y satisfy 5≤u≤7, 1≤v≤3, 12≤w≤14, 12≤x≤18, and 60≤y≤65, εᵣ of 99 or greater, Qᵤxf₀ of 6100 GHz or greater, and τ_{f} of -9 to 12 ppm/°C can be secured.

Further, where 4≤u≤8, 0≤v≤3, 12≤w≤15, 16≤x≤19, 32≤y≤35, and 28≤z≤32, it is possible to obtain εᵣ of 58 or greater and Qᵤxf₀ of 10080 GHz or greater.

It has been known that many dielectric materials having a perovskite structure exhibit excellent dielectric characteristics. The dielectric ceramic material according to the present invention is considered to be a solid solution structure made up of Ca₁₋ₓSm_{2x/3}TiO₃ that has a perovskite structure and exhibits a very high εᵣ value, a large Qᵤxf₀ value, and a positive τ_{f} value; Li_{1/2}Sm_{1/2}TiO₃ that has a perovskite structure and exhibits a high εᵣ value and a large τ_{f} value in the minus side; and Na_{1/2}Sm_{1/2}TiO₃ that has a perovskite structure and exhibits a large Qᵤxf₀ value and a large τ_{f} value in the plus side. The excellent dielectric characteristics of the ceramic material of the invention seems attributed to this structure. Where the dielectric ceramic material of the invention has such a solid solution composition or a nearly solid solution composition, it is possible to obtain εᵣ of nearly 100, Qᵤxf₀ of about 6000 GHz, and τ_{f} of around 0 ppm/°C. Where part of Ti⁴⁺ contained in the structure is replaced with at least one of Ga³⁺ and Al³⁺, whose ionic radius is relatively close to that of Ti⁴⁺ and whose valence is different from that of Ti by +1, Qᵤxf₀ is improved. Further, the value of τ_{f} can be controlled by varying the proportions of Li oxide and Na oxide, which exhibit τ_{f} values of opposite signs.

### Examples

The present invention will now be illustrated in greater detail by way of Examples.

Predetermined amounts of commercially available powders of Li₂CO₃ (purity: 99%), Na₂CO₃ (puri ty: 99%), Sm₂O₃ (purity: 99.9%, D50: 1.9 µm), CaCO₃ (purity: 99.9%, D50: 2.6 µm), TiO₂ (purity: 99%, Average particle size: 0.25 µm), Al₂O₃ (purity: 99. 9%, Particle size: 2 to 3 µm) and Ga₂O₃ (purity: 99.9%) were weighed out (100 g in total) to give the final composition shown in Table 1 below in terms of the respective oxides.

The powders were wet mixed in a ball mill for 15 hours using ethanol as a medium, and the resulting slurry was dried on a hot water bath and calcined in the air atmosphere at 1000°C for 2 hours. The calcined product was wet ground for 15 hours in a ball mill together with a wax binder, a dispersant, and ethanol. The resulting slurry was dried on a hot water bath, granulated and compacted under a pressure of 10 MPa into a rod form of 20 mm in diameter and 12 mm in thickness. The rod compact was subjected to cold isostatic pressing (CIP) under a pressure of 150 MPa, and then sintered by firing at 1300°C for 5 hours in the air atmosphere to obtain a sintered body.

After surface of the resulting sintered body, i.e., a dielectric material, was ground with a #200 diamond, εᵣ, Qᵤ, and τ_{f} were measured by the Hakki and Coleman's method in a measuring frequency range of from 1 to 3 GHz at a measuring temperature of from 25 to 80°C. The τ_{f} value was calculated according to equation: τ_{f} = (f₈₀ - f₂₅) /{ (f₂₅ x (80 - 25)} x 10⁶, wherein f₂₅ is a resonance frequency at 25°C, and f₈₀ is a resonance frequency at 80°C.

The results obtained are shown in Table 1.

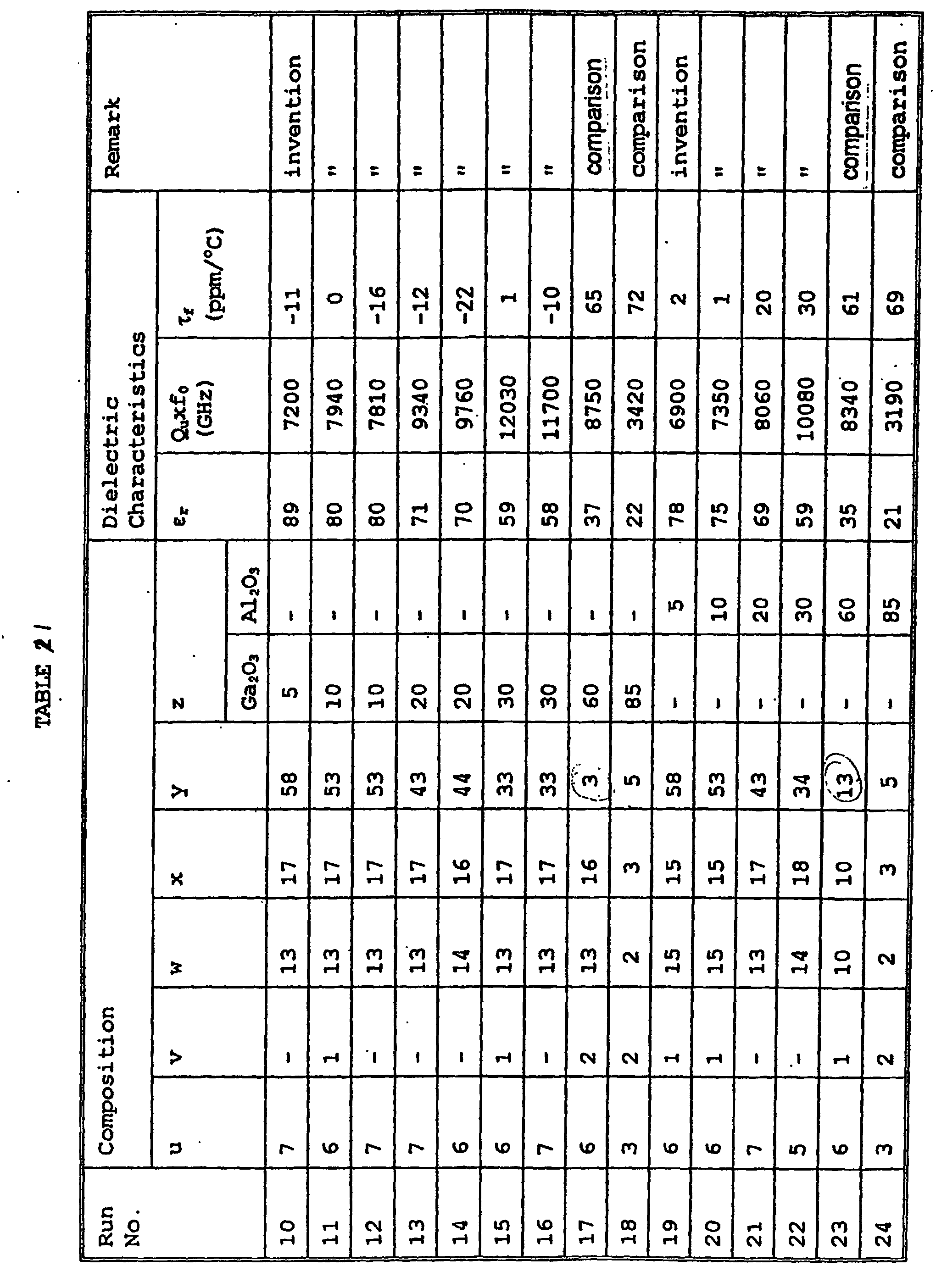

The results in Table 1 prove that the Qᵤxf₀ value increases to 7200 to 12030 GHz with an increase in degree of substitution of Ti with Ga (Run Nos. 10 to 16) and increases to 6900 to 10800 GHz with an increase in degree of substitution of Ti with Al (Run Nos. 19 to 23). It can be seen accordingly that the Qᵤxf₀ value can be controlled by substituting Ti with at least one of Ga and Al.

### (1) A First Example of Dielectric Filter Prepared by Using Dielectric Material of the Invention

The dielectric material of the present invention may be used in a dielectric filter described in USP 5,612,654, hereby incorporated by reference.

For example, the dielectric filter shown in Figs. 1A and 1B includes resonator holes 202a and 202b.

In the structure shown in Figs. 1A and 1B, the coupling between the two resonators formed at resonator holes 202a and 202b is inductive coupling, and one attenuation pole is formed in the high frequency range of the pass band. A pair of input/output electrodes 205 are formed at prescribed portions on the outer surface of dielectric block 201. Inner conductors 203 are formed on the inner surfaces of resonator holes 202a and 202b.

The dielectric ceramic material having composition formula: (uLi₂O-vNa₂O)-wSm₂O₃-xCaO-yTiO₂-zM₂O₃ exhibits excellent dielectric characteristics. Qᵤxf₀ can be controlled in a range of large values by substituting Ti in the composition formula with Ga or Al. Further, the value τ_{f} is controllable by adjusting the proportions of Li and Na.

## Claims

1. A dielectric ceramic material represented by the composition formula: (uLi₂O-vNa₂O)-wSm₂O₃-xCaO-(yTiO₂-zM₂O₃), wherein M represents at least one of Ga and Al; u+v+w+x+y+z=100 mol%, 0≤u≤40, 0≤v≤40, 3≤u+v≤40, 8≤w≤30, 5<x≤40, 30≤y, 3≤z, and y+z≤80.

2. A dielectric ceramic material according to claim 1, wherein 3≤u≤40, and 0≤v≤30.

3. A dielectric ceramic material according to claim 1 or 2, wherein 40≤y, and z<40.

4. A dielectric ceramic material according to any one of claims 1 to 3, wherein M represents Ga.

5. A dielectric ceramic material according to any one of claims 1 to 3, wherein M represents Al.

6. A dielectric ceramic material according to any one of claims 1 to 5, wherein u+v≤15.

7. A dielectric ceramic material according to any one of claims 1 to 6, wherein 5≤u+v≤8.

8. A dielectric ceramic material according to any one of claims 1 to 7, wherein w≤20.

9. A dielectric ceramic material according to any one of claims 1 to 8, wherein 10<w≤16.

10. A dielectric ceramic material according to any one of claims 1 to 9, wherein x≤30.

11. A dielectric ceramic material according to any one of claims 1 to 10, wherein 9<x≤18.

12. A dielectric ceramic material according to any one of claims 1 to 11, wherein y≤77.

13. A dielectric ceramic material according to any one of claims 1 to 12, wherein 50≤y≤75.

14. A dielectric ceramic material according to any one of claims 1 to 13, wherein 33≤y+z≤75.

15. A dielectric ceramic material according to any one of claims 1 to 14, wherein 60≤y+z≤70.

16. A dielectric ceramic material according to any one of claims 1 to 15, wherein y≤60 and z≤35.

17. A dielectric filter comprising a dielectric ceramic material according to any one of claims 1 to 16.

## Patentansprüche

1. Dielektrischer keramischer Werkstoff, der durch die Formel der Zusammensetzung (uLi₂O-vNa₂O)-wSm₂O₃-xCaO-(yTiO₂-zM₂O₃) wiedergegeben wird, wobei M wenigstens eines der Elemente Ga und Al bedeutet, u+v+w+x+y+z = 100 mol%, 0≤u≤40, 0≤v≤40, 3≤u+v≤40, 8≤w≤30, 5<x≤40, 30≤y, 3≤z und y+z≤80.

2. Dielektrischer keramischer Werkstoff nach Anspruch 1, wobei 3≤u≤40 und 0≤v≤30.

3. Dielektrischer keramischer Werkstoff nach Anspruch 1 oder 2, wobei 40≤y und z<40.

4. Dielektrischer keramischer Werkstoff nach einem der Ansprüche 1 bis 3, wobei M Ga bedeutet.

5. Dielektrischer keramischer Werkstoff nach einem der Ansprüche 1 bis 3, wobei M Al bedeutet.

6. Dielektrischer keramischer Werkstoff nach einem der Ansprüche 1 bis 5, wobei u+v≤15.

7. Dielektrischer keramischer Werkstoff nach einem der Ansprüche 1 bis 6, wobei 5≤u+v≤8.

8. Dielektrischer keramischer Werkstoff nach einem der Ansprüche 1 bis 7, wobei w≤20.

9. Dielektrischer keramischer Werkstoff nach einem der Ansprüche 1 bis 8, wobei 10<w≤16.

10. Dielektrischer keramischer Werkstoff nach einem der Ansprüche 1 bis 9, wobei x≤30.

11. Dielektrischer keramischer Werkstoff nach einem der Ansprüche 1 bis 10, wobei 9<x≤18.

12. Dielektrischer keramischer Werkstoff nach einem der Ansprüche 1 bis 11, wobei y≤77.

13. Dielektrischer keramischer Werkstoff nach einem der Ansprüche 1 bis 12, wobei 50≤y≤75.

14. Dielektrischer keramischer Werkstoff nach einem der Ansprüche 1 bis 13, wobei 33≤y+z≤75.

15. Dielektrischer keramischer Werkstoff nach einem der Ansprüche 1 bis 14, wobei 60≤y+z≤70.

16. Dielektrischer keramischer Werkstoff nach einem der Ansprüche 1 bis 15, wobei y≤60 und z≤35.

17. Dielektrischer Filter, umfassend einen dielektrischen keramischen Werkstoff nach einem der Ansprüche 1 bis 16.

## Revendications

1. Matériau céramique diélectrique représenté par la formule de composition :
(uLi₂O-vNa₂O)-wSm₂O₃-xCaO-(yTiO₂-zM₂O₃),
dans lequel M représente au moins un élément parmi Ga et Al ; u+v+w+x+y+z=100 mol%, 0≤u≤40, 0≤v≤40, 3≤u+v≤40, 8≤w≤30, 5<x≤40, 30≤y, 3≤z et y+z≤80.

2. Matériau céramique diélectrique selon la revendication 1, dans lequel 3≤u≤40 et 0≤v≤30.

3. Matériau céramique diélectrique selon la revendication 1 ou 2, dans lequel 40≤y et z<40.

4. Matériau céramique diélectrique selon l'une quelconque des revendications 1 à 3, dans lequel M représente Ga.

5. Matériau céramique diélectrique selon l'une quelconque des revendications 1 à 3, dans lequel M représente A1.

6. Matériau céramique diélectrique selon l'une quelconque des revendications 1 à 5, dans lequel u+v≤15.

7. Matériau céramique diélectrique selon l'une quelconque des revendications 1 à 6, dans lequel 5≤u+v≤8.

8. Matériau céramique diélectrique selon l'une quelconque des revendications 1 à 7, dans lequel w≤20.

9. Matériau céramique diélectrique selon l'une quelconque des revendications 1 à 8, dans lequel 10<w≤16.

10. Matériau céramique diélectrique selon l'une quelconque des revendications 1 à 9, dans lequel x≤30.

11. Matériau céramique diélectrique selon l'une quelconque des revendications 1 à 10, dans lequel 9<x≤18.

12. Matériau céramique diélectrique selon l'une quelconque des revendications 1 à 11, dans lequel y≤77.

13. Matériau céramique diélectrique selon l'une quelconque des revendications 1 à 12, dans lequel 50≤y≤75.

14. Matériau céramique diélectrique selon l'une quelconque des revendications 1 à 13, dans lequel 33≤y+z≤75.

15. Matériau céramique diélectrique selon l'une quelconque des revendications 1 à 14, dans lequel 60≤y+z≤70.

16. Matériau céramique diélectrique selon l'une quelconque des revendications 1 à 15, dans lequel y≤60 et z≤35.

17. Filtre diélectrique comprenant un matériau céramique diélectrique selon l'une quelconque des revendications 1 à 16.
